Europäisches Patentamt

(19) European Patent Office

Office européen des brevets

(11) Publication number: **0 452 275 A1**

# (12) EUROPEAN PATENT APPLICATION

(21) Application number: 91810259.1

(22) Date of filing: 09.04.91

(51) Int. Cl.$^5$: **C04B 38/00**, C04B 35/80, B32B 17/00, H01L 41/22, C04B 41/81, C22C 1/10, C04B 37/02

(30) Priority: 12.04.90 EP 90810295

(43) Date of publication of application:
16.10.91 Bulletin 91/42

(84) Designated Contracting States:
BE CH DE FR GB IT LI NL SE

(71) Applicant: BATTELLE MEMORIAL INSTITUTE
7 route de Drize
CH-1227 Carouge/Genève (CH)

(72) Inventor: Issartel, Jean-Paul
190 Chemin des Nants
F-74380 Cranves-Sales (FR)
Inventor: Richon, Dominique
60 rue Maurice Ravel
F-74100 Ville-la-Grand (FR)
Inventor: Sandoz, Nicolas
12 Rue des Jardins
CH-1205 Geneve (CH)

(74) Representative: Dousse, Blasco et al
7, route de Drize
CH-1227 Carouge/Genève (CH)

(54) Method for manufacturing articles of functionally gradient material.

(57) In order to integrally bind two component materials of different nature and affinity, there is provided between the two an intermediate phase in which both materials are intimately admixed together in proportions that vary according to a given pattern. For achieving said intermediate phase, one of the materials is made with varying porosity and the second material is brought into the pores in the fluid state and thereafter solidified.

EP 0 452 275 A1

The present invention concerns the manufacture of composite bodies or articles involving at least two materials of different nature and different physical properties, for instance ceramics and metals, or glasses, or plastics, the two materials having no affinity for each other being linked together through a transition phase in which the two materials are in admixture and present in varying amounts i.e. the proportion of one material increases in the mixture while the proportion of the other decreases. For instance, in a block formed of a first component layered over a second component, there is used a transition phase richer of the first component in the vicinity thereto and progressively leaner in the direction of the second component, the proportions of the second component in this phase varying in reverse relationship. Or stated differently, the transition phase consists of a mixture of the two components in graded ratio, the ratio gradient being linearly progressive or following a profile of any desired kind.

Composite bodies or articles made of Functionally Gradient Materials (FGM) of the kind involved in this invention can be useful in many technical fields where materials of different natures must be bonded securely despite obvious differences in properties such as thermal expansion, mutual affinity, strength, ductility, resistance to shocks and the like. Among the possible technical fields, one may cite space technologies where the binding of high temperature protective ceramic screens to metal structures poses serious problems; nuclear power plants in which very high temperature ceramics in nuclear reactors are bonded to metals; electrochemical cells such as fuel cells or lambda probes in which ceramic electrolytes are made integral with electronically conductive elements; acoustics in which impedance matching resins are mated with piezo-actuators to make transducers and thermal engines in which fire-resistant ceramic linings are coupled to metal parts such as pistons or cylinder heads.

The concept of Functionally Gradient Materials (FGM) has been coined in connection with such variable property and composition transitional phases.

Several fabrication methods for FGM have been proposed including (1) Chemical or Physical Vapor Deposition (CVD, PVD), (2) plasma spray coating, (3) powder metallurgy and (4) high temperature diffusion. In CVD, gaseous reactants are allowed to mix and react on a surface to be coated and the products of reactions which are deposited thereon are progressively varied as the reaction progresses by continuously changing the ration of reactants in the mixture.

In the plasma spray technique (2), at least two materials are sprayed together or by successive increments, the spraying ratio of both being also changed with increase of thickness of the sprayed deposit.

In powder metallurgy (3), a plurality of layers made, for instance, from tape-cast slurries of metal and ceramic powders are stacked over each other into a block and the latter is compacted and sintered at temperature over 1600°C. The ratio of metal and ceramic varies progressively from one layer to the next so, after high temperature densification, a body of composition changing progressively from metal to ceramic (or vice-versa) is obtained. This technique is versatile because it allows to make complex structures, often with more than two components, and the thickness of the transition phase can be tailored at will, i.e. it can be of less than 1 mm or reach several cm if desired. In document EP-A-229 552, there is disclosed a method for making composites of two components, for instance, a ceramic and a metal or another ceramic. In these composites, the components are bound by an intermediate layer of a mixture of the components in which the ratio of both components varies progressively. The techniques for making the intermediate layers may involve impregnation of a porous layer of one component by vapors of the second component (CVD technique). Otherwise, one may rely on a fractional sedimentation technique, e.g. one uses as components powders of particles of Ni and zirconia of different grades which are entrained in an air flow and which are allowed to settle in a cyclone (see figure 9). The settling rate will depend on the grade of the particles and on the relative proportion of the components in the air flow, and by adjusting the parameters, one achieves a sediment in which the proportions of the components varies progressively. Afterwards, the sediment is consolidated by firing under pressure. This technique is however not convenient for binding ceramics and, as second component, lower melting components such as glass, plastics, or metals with melting temperatures below about 1000-1500°C because the second component would decompose or melt away during sintering.

In document EP-A-250 210, there is disclosed a method of fabricating metal-ceramic composites involving making first a porous ceramic precursor and thereafter infiltrating the precursor with a molten metal. One technique to make the porous ceramic precursor is gravitational settling filtration casting (page 4, lines 55-56) using particles with controlled polymodal size distribution which allows to achieve porosities from about 10 vol % to more than 80 vol %. In order to bring about the technique, one disperses ceramic particles of, for instance, two different grades (Example 2 of the document recites $B_4C$ particles of 0.2 µm and 0.8 µm) in a liquid, and one filter-casts this slurry, thus forming a cake which is thereafter consolidated by pressing (10.000 psi). The preform is then heated in a crucible with powdered aluminium to temperatures higher than the melting of aluminium whereby the latter being liquid totally impregnates the porosity of the structure.

The present invention is based on a similar technique but with the fundamental difference that the porous structure is consolidated by pressureless sintering at temperatures preferably above 1000°C before being contacted with a second component, for instance a metal, in liquid form. It was indeed noted that the technique disclosed in EP-A-250 210 leads to a disconnected porous morphology, i.e. the ceramic grains are not fused together and are preferably surrounded by metal (see page 3, lines 43-44). In the present invention, such a structure is not desirable because it does not lead to optimalized bonding properties between the components of the composite. Actually, for optimal bonding properties, a fused grain connected morphology is mechanically stronger and preferable, and it may contain some residual closed pores that offer thermal insulation properties and reduced stress due to thermal stocks.

The method of the present invention is summarized in the annexed claims.

The method according to annexed claim 1 remedies some drawbacks of the prior art. In this method, the components to be bonded, i.e. for instance a ceramic and a metal can be produced simultaneously and integrally with the transition phase, i.e. the pure ceramic and metal component can be generated in the method together with the transition phase, whereby step (4) in the method can be omitted or, otherwise, the transition phase can be made independently, i.e. the thickness of the pure metal and ceramic which limit said transition phase can be made negligibly small or immaterial and the components proper can be bonded thereto in consecutive or subsequent steps, e.g. sintering (on the ceramic side) or soldering or welding (on the metal side).

The morphology of the structure of the ceramic portion with graded porosity is largely open with fused grain sintered configuration; however a proportion of total porosity may consist of closed pores non-infiltrable by the non-ceramic component in fluid form. This proportion may be in the order of 0.1 to about 9%, preferably in the range of 1-2%. The closed pores are dispersed throughout the structure and have a vibrational damping and thermal insulating effect; however the density of the non-infiltrated porosity should not exceed the indicated values for fear of unduly decreasing the overall mechanical strength of the composite.

The fused grain connected morphology desirable for the porous structure of the binding transition phase is obtained by firing at temperatures preferably above 1000°C, most preferably between 1300 and 1600°C, depending on the type of ceramic used.

As indicated in claim 1, a first step of the method of the invention involves making a porous structure on a side of a first component, that is the most high temperature resistant component, for instance a ceramic component. Then this porous structure is contacted with the second component, the latter being temporarily made into a fluid (a gas or a liquid) to impregnate the open pores of the porous structure. The second component, for instance can be a metal in the molten state, or it can be a precursor of the metal, i.e. a metal compound in liquid or dissolved form which, upon further treatment, can generate the metal within the open porosity of the porous ceramic. Alternatively, the metal can be in vapor form which will infiltrate the pores and deposit therein by cooling. The filling of the open pores need not be complete so as to leave further space after infiltration, this being for later infiltrating one or more metal or other materials, or to be left free if desired like the residual closed porosity.

In the present description, reference is made to ceramics and metals; this is purely for description convenience because many other materials can be impregnated in the pores of the porous structure including resins (by introducing them in molten or in monomeric form, that is a form which is subsequently cured by polymerization) or glasses or any materials which can be brought in a gaseous or liquid form and which can be later made to solidify within the pores of the porous structure. One may also visualize impregnating the porous structure with gaseous or liquid reactant mixtures which will be subsequently caused to react in the pores and fill them or coat the inside surface thereof with reaction products. This is particularly so for instance with complex ceramic structures, i.e. a porous base structure whose pores are first surface coated with another ceramic brought therein by CVD, e.g. BN, $Si_3N_4$, TiN and the like, and thereafter filled with a metal in the molten state or in the form of a decomposable compound.

According to a first embodiment of making the porous structure of step (1) of the method (differential gravitational settling), a slurry is made using ceramic particles of two different mesh grades, for instance one ceramic is in the 30-300 μm grade range and the other ceramic is in a 0.1-30 μm range. The slurry is made according to usual means in the ceramic field, i.e. using a liquid phase (usually aqueous) with binders, dispersants, sintering aids and other convenient additives. The slurry is placed in a mould with a liquid absorbent bottom (and/or walls, e.g. a filter or slip-casting mould) and settling is allowed to occur under gravitation (earth gravitation or artificially created gravitation, i.e. centrifugation). Settling can also be accelerated by additional sonication (acoustic or ultrasonic). During settling, the ceramic particles will segregate, i.e. the larger ones will drop to the bottom faster than the small ones and, after a time, a gradient of smaller and larger particles will result, the interval between the particles being filled with liquid. This liquid will ultimately be drained through the mould bottom (under atmospheric pressure or under succion with reduced pressure) and, after drying and consolidating, there will remain a graded dry edifice with larger particles at bottom and smaller particles going upwards. The preform (green form) is strong enough to be manipulated because of the binders remaining between the particles, hence the green can be placed in an oven and fired at sinter temperature under usual conditions so that a fused connected structure will result. Firing causes the side of the block with the smaller particles to densify to substantially zero porosity whereas the porosity will increase in volume throughout the block in the direction of the coarser particles. This porosity is mostly open so it can be impregnated with a liquid by usual means to be described later.

The profile of the porosity gradient can be controlled by several parameters including the ratio of fine and coarse particles in the original slurry, the respective size of said particles, the density of the particles, the density and viscosity of the liquid phase and the liquid draining rate of the mould (or filter). In this connection, it should be noted that the mould can be made of materials with absorbent properties (porous resins or ceramics or plaster). Also, the aqueous phase can contain hydrophilic resins or gels in solution or dispersion to help controlling ceramic particles segregation and build-up of the desired porous edifice. Such resins will include polysaccharides like starch, dextran, and cellulose derivatives (hydroxymethyl- or carboxymethyl-cellulose), polyvinyl-alcohol, polyalkylene-glycols, polyvinylpyrrolidone and the like. These resins will be volatilized during firing of the green.

Alternatively, the slurry can contain particles of only one ceramic mesh grade and insoluble heat decomposable particles which will segregate by buoyancy. As an example, the slurry can contain, in addition to a ceramic in the 0.1-30 $\mu$m range, a proportion of carbon particles in the 10 $\mu$m range and a proportion of carbon particles in the 100 $\mu$m range. During settling, the larger carbon particles will rise faster than the smaller carbon particles and the ceramic particles will slowly decant toward the bottom. Hence after a period of time, a stratified structure will result with much ceramic at the bottom and little ceramic near the top, large carbon particles near the top and smaller carbon particles around the middle, and nearly no carbon particles at the bottom. After draining the liquid and drying the structure, a green preform is therefore obtained which, upon subsequent firing and burning the carbon particles, will generate an increased density of porosity in the upward going direction. Naturally the carbon particles can be replaced by other particles of any heat decomposable materials, i.e. resin micro-beads. In order to help establishing the desired gradient the slurry can also contain foamers which will generate bubbles during mixing or upon standing; the bubbles will rise in function to their size, the larger ones faster than the smaller ones, and the size of the voids due to the bubbles will increase in the upper direction.

In a second type of embodiment for making the porous structures of step (1), one may use slurries of mixtures of mineral particles and fibers or whiskers. The mineral fibers and whiskers may include fibers of $Al_2O_3$, quartz, silicoaluminates, carbon, SiC and $ZrO_2$; the whiskers may include $Si_3N_4$, SiC, TiN and the like; the particles may include $ZrO_2$, $Y_2O_3$, lanthanum manganate, AlN, BN, TiN, SiC, TiC, WC, $BaTiO_3$, PZT ceramics and the like. The method comprises making a series of slurries each containing, besides usual sintering additives, a different proportion of particles and fibers. Then the slurries are carefully layered upon each other in a porous mould, taking care that the addition of a new layer will not disturb the previous layers. A mean to do that safely is to start with a pure fiber layer and place just on top of it a displaceable screen the presence of which will regularize the spreading of the next layer containing much fibers and few particles. The screen is then carefully lifted to rest on top of the second layer just introduced and the process is repeated until all successive layers have been added, the latter being that of pure particles. Hereafter the ensemble is drained and consolidated by drying as usual aid the stack is fired as usual. The porosity increases in the direction of increasing fiber/particle ratio.

The porous structure to be obtained in step (1) of claim 1 can also be obtained by classic stacking means using a plurality of tape-cast films of progressively varying composition. For instance, a series of slurries containing a ceramic and carbon particles (or particles of any heat decomposable material) in varying ratios can be made in a liquid phase with other sintering additives and tape-cast films in green form can be prepared from these slurries. Then a stack of these green films, each having a ceramic/carbon ratio that varies from the previous and next ones according a given pattern, is compacted and fired, during which the carbon (or other volatilizable material) will vanish to leave a variable porous density structure to be used in the next step of the invention.

It should be noted at this stage that in all embodiments of this invention involving heat-decomposable particles, the latter can be associated with materials designed to permanently remain in the final composite. For instance, carbon or resin particles can be coated before using them for making slurries with a layer of metal or ceramic by usual means, e.g. by CVD, electroless or electrochemical means. After removal of the heat-decomposable particles, such coating of metal or ceramic will remain in the structure as an internal coating of the pores thereof and will serve to impart special properties to the final composite.

In this connection, it should also be noted that electrochemical means can also be used to enhance the segregation of particles of different natures in bulk slurries where a property gradient must be established, particularly if some particulate components can acquire electrical charges (ionic or electrostatic); in this case the migration can result from the application of an electric field and relates to electrophoresis phenomena.

Impregnation of the porous structures obtained in step (1) of the method of the invention by a second component (step (3)) can be carried out according to usual means known in the field of ceramic capacitors and piezo-actuators (see for instance GB-A-2,162,371, 29.1.86, AVX Corp.; GB-A-2,115,223, 1.9.83, Standard Telephones & Cables). For instance, a liquid with either a suspension of metal particles or a solution of a metal compound to be subsequently decomposed into said metal is impregnated into the open voids of the porous structure so as to fill these voids with the liquid. Thereafter the vaporizable components are removed by evaporation under atmospheric or reduced pressure and final decomposition to provide the metal in elemental form is carried out by heat with or without a reactive atmosphere.

Otherwise, the voids of the porous structure are filled with a molten metal by immersing the ceramic matrix in a bath of the metal under reduced pressure and thereafter applying pressure to force the molten metal into the pores. The metals to be selected in molten form in step (2) of claim 1 are those with a melting point not exceeding the ceramic sintering temperatures, i.e. from about 300 to about 1500°C; examples of such metals include Cu, Ni, Ag, Pb, Sn, Al, brass, bronze, Mg and alloys. For higher melting metals the technique with decomposable salts or organo-metallic precursors is preferable.

The ceramics which can be used in this invention are any ceramic or ceramic mixtures to be contemplated in the fields where FGM are applicable, for instance metal oxides such as $Al_2O_3$, $ZrO_2$, $Y_2O_3$, mullite, aluminosilicates, $SiO_2$, ZnO and the like; nitrides such as $Si_3N_4$, AlN, BN, TiN, etc. carbides such as SiC, TiC, WC, etc.; the ferro-electric ceramics such as barium and zirconium titanate, lead zirconate/titanate and the like; and the solid electrolytes containing rare-earth compounds.

The polymer resins which may be used as the non-ceramic component will include thermoplastics such as polyethylene, polypropylene, polyamides, polyesters, PVC, polyacrylates and the like. In general these resins are infiltrated into the pores of the porous structure in the molten state. Non-fusible resins like polyurethanes or cross-linked polyepoxies are generally added as monomers or monomer mixtures which harden thereafter in the pores by reaction at room or elevated temperature.

In order to practically achieve step (3) of the invention, the gradient porous ceramic is generally added in a mould together with the amount of component necessary to fill the pores, or an excess thereof, so as to provide, afterwards, a layer of said component in pure form bonded to the structure. Naturally the invention is also suitable for making metal/ glass FGM for instance by infiltrating a gradient porous metal matrix with molten glass.

It should be noted that this invention can also be used for making composites with no ceramic, i.e. metal/plastic composites, in which case a sintered metal matrix with graded porosity is made according to the same techniques disclosed heretofore, and the graded porosity metal matrix is infiltrated with a resin in the molten state.

The following Examples illustrate the invention on a practical standpoint.

### Example 1

A slurry of the following blend was milled for 24 hrs in a ball-mill.

| | | |
|---|---|---|
| $ZrO_2$ (TOSOH TZ8Y) | 60 | g |
| Graphite powder (CARBONE LORRAINE No. 7388); 1-20 μm particles | 15 | g |
| Graphite powder; 20-120 μm | 25 | g |
| Sodium hexametaphosphate deflocculant | 0.2 | g |
| TRITON X-100 non-ionic surfactant (ROHM & HASS); polyalkylaryl-ether-alcohol | 1.0 | g |
| Sodium carboxymethyl-cellulose (CMC) binder | 0.5 | g |
| Deionized water | 50 | g |

The slurry (120 ml) was placed in a mould of plaster of Paris (water/plaster ratio = 70/10 by weight) and allowed to rest for 24 hrs with occasional ultrasonication (30 KHz). During that period, the water slowly leaked out into the mould walls; simultaneously, the coarser carbon particles tended to rise toward the surface of the slurry, while the smaller carbon particles remained distributed near the center (density about 1) and the $ZrO_2$ particles tended to settle to the bottom. Hence a gradient preform structure was obtained.

The preform was dried in warm air after which it was placed in a furnace and slowly heated to 1000°C (30°C/hr). Then the heating rate was raised to 300°C/hr until the temperature became 1550°C which was kept for 2 hrs. Then the fired fused article was cooled to room temperature (cooling rate 300°C/hr). During firing, the carbon powder was burned out and a graded porosity structure over a fully densified ceramic substrate was thus obtained.

The sintered component was then placed in a graphite mould with the porous side up and a 300 g Ni slab was placed over it. The mould was put in a vacuum enclosure and surrounded by an induction heating device. A reduced pressure of a few Torr was established and the pot was heated to 1550°C to melt the Ni. When the latter was liquid it was driven into the porous structure by releasing the vacuum with argon and then raising the pressure to 15 bar approximately.

After cooling an article was obtained with one face of pure ceramic and the other face of pure nickel; the thickness of the intermediate bonding phase with varying ratio of ceramic and nickel was approximately 20 mm.

By reducing the amount of carbon in the slurry and using a larger diameter slip-casting mould during segregation, a much thinner FGM layer (2.5 mm) can be obtained.

Example 2

A series of slurries (21-26) containing in parts by weight:

| | |
|---|---|
| Polyvinylbutyral (binder) | 16 |
| Polyethylene-glycol (plasticizer) | 5 |
| Dioctyl-phthalate (plasticizer) | 3 |
| Fish-oil (deflocculant) | 1 |
| 1:1 mixture of trichlorethylene and ethanol (solvent) | 85 |

and variable amounts of $ZrO_2$ powder (TOSOH TZ8Y) and graphite powders (< 20 μm, ref. 7388) and from an average of 20 μm up to 120 μm (ref. 1004) were prepared according to the table below (parts by weight).

| Slurry No. | $ZrO_2$ | Carbon ref.7388 | Carbon ref.1004 |
|---|---|---|---|
| 21 | 100 | 0 | 0 |
| 22 | 70 | 30 | 0 |
| 23 | 60 | 40 | 0 |
| 24 | 40 | 60 | 0 |
| 25 | 40 | 30 | 30 |
| 26 | 40 | 0 | 60 |

The above slurries were used for tape casting films by standard techniques, i.e. depositing a 500 μm layer on a 30 mm polyester fabric tape with a doctor blade, then drying the films, peeling off and cutting the peeled off films into 30 x 30 mm squares. Block of 6 films were prepared by stacking up in incremental order dry films issued from slurries 21 to 26 and laminating under 25 MPa at 75°C. The blocks were found to develop porosity like described in Example 1 and, thereafter, infiltrated with molten Al-Cu alloy. Copper/zirconia articles bonded by an FGM layer containing Cu and $ZrO_2$ in varying amount were thus obtained. The adhesion between the components was excellent.

EP 0 452 275 A1

## Example 3

A slurry was prepared with the following ingredients (by weight):

```
Al2O3 powder ALCOA XA-1000SG
(average particle size < 0.5 µm)          60    g
Al2O3 powder ALCOA A-14
(average particle size 4-5 µm)            30    g
Al2O3 powder ALCOA A-5
(average size 8-10 µm)                    10    g
MgO                                       0.1   g

Na-hexametaphosphate defloculant         0.2   g
Na-CMC binder                            0.5   g
Deionized water                          50    g
```

The slurry was allowed to settle in an absorbing mould of about 5 cm internal radius. After a few hours standing, the slurry had sedimented into a cake with the larger particles at the bottom and the finer particles at the top.

The cake was dried and fired as disclosed in Example 1 which left a cylinder about 10-12 mm high having one side of dense non-porous $Al_2O_3$ and the other side with a porosity increasing in a direction away therefrom. The pores of the structure which were 95% open were thereafter infiltrated with molten copper by the technique described in Example 1, the amount of molten metal being sufficient to provide a layer of solid alloy coated on the face of coarser porosity. Hence a copper/alumina composite was obtained, the metal and ceramic components being integrally bonded by a transition phase containing simultaneously alumina and copper.

## Example 4

A series of sprayable slurries (41-46) were prepared containing (by weight) 16 g of polyvinylbutyral, 5 g of polyethylene glycol, 3 g of dioctylphtalate, 1 g of fish-oil and 130 g of trichlorethylene/ethanol (1:1) and variable quantities of $ZrO_2$ powder as well as fine and coarse carbon powders according to the table below.

| Slurry No. | $ZrO_2$ (TOSOH TZ8Y) | C-particles $\leq 20$ µm | C-particle 20-120 µm |
|---|---|---|---|
| 41 | 100 | 0 | 0 |
| 42 | 70 | 30 | 0 |
| 43 | 60 | 40 | 0 |
| 44 | 40 | 60 | 0 |
| 45 | 40 | 30 | 30 |
| 46 | 40 | 0 | 60 |

A compact green ceramic body (50 x 50 mm, 5 mm thick) was made using TZ8Y $ZrO_2$, pressing under 30 MPa and preheating for 2 hrs at 700°C. Then slurry No. 41 was sprayed over the body using an enamelling pistol to provide a layer about 200 µm thick. After drying, slurry No. 42 was sprayed over the first layer and, thereafter, successively the remaining slurries No. 43 to 46. The dry block was dried and fired at 150°C to burn the carbon powder which gave a structure with increasing porosity (98% open) in the direction away from the dense ceramic side. Infiltration with metal (350°C molten Sn-Pb alloy) was carried out as disclosed in Example 1.

As a variant of the above, the successive slurry layers were applied by dip-coating instead of spraying, i.e. the prefired ceramic body was contacted with slurry No. 42 first to provide a layer with few carbon particles,

7

then after drying this first layer, the process was repeated using, successively, the other slurries. Firing and impregnation were effected as above.

Example 5

A series of slurries (51-60) were prepared containing by weight 16 parts of polyvinylbutyral (binder), 5 g of polyethylene-glycol (plasticizer), 3 g of dioctylphthalate (plasticizer), 1 g of fish-oil (deflocculant), and variable amounts of solvent (1:1 mixture of trichloroethylene and ethanol), alumina powder with particle size below 0.5 $\mu$m (ALCOA XA-1000SG), MgO powder and SiC whiskers of 1 $\mu$m average diameter (TOKAI CARBON). These proportions are given in the table below:

| Slurry No. | XA-1000SG | MgO | SiC | Solvent |
|---|---|---|---|---|
| 51 | 100 | 0.5 | 0 | 85 |
| 52 | 95 | 0.5 | 5 | 85 |
| 53 | 90 | 0.45 | 10 | 85 |
| 54 | 85 | 0.45 | 15 | 80 |
| 55 | 80 | 0.40 | 20 | 80 |
| 56 | 75 | 0.40 | 25 | 80 |
| 57 | 70 | 0.35 | 30 | 80 |
| 58 | 65 | 0.35 | 35 | 70 |
| 59 | 60 | 0.30 | 40 | 70 |
| 60 | 50 | 0.25 | 50 | 70 |

The above slurries were converted to dry films (51-60) by the tape casting procedure detailed in Example 2, after which stacks were made under 25 MPa with ten films each, the order of stacking being of increasing proportions of SiC whiskers which corresponds to increasing order of porosity. After burning in air and sintering at 1600°C under argon, there were obtained blocks of densified alumina on one side and increasing porosity in the direction of the opposite side. Impregnation with molten metal was carried out as in the previous Examples. Closed pore volume was about 4-6%.

In a modification of the above Example, green laminated bodies were made of layers deposited successively from slurries 51 to 60 by the dip-coating technique mentioned in Example 4.

Example 6

The variable porosity block described in Example 1 was used for impregnation with molten glass at temperature of 1200°C. A composite was obtained one face of which was ceramic and the other side glass, the bonding between the two phases being assured by a gradient glass/ceramic mixture.

Example 7

A series of slurries (71-80) were prepared in the mode described in Example 5 but replacing the alumina and magnesium oxide powders by a piezo-electric ceramic powder (PZT501 A, Ultrasonics Powders Inc.) and the SiC whiskers were replaced by corresponding amounts of graphite powder $\leq$20 $\mu$m (CARBONE LORRAINE, ref. 7388). Piezo-ceramic chips were made (numbered 71 to 80) with each slurries using the tape casting method (see Example 2). The proportion of graphite powder and hence the intrinsic porosity of the tape-cast chips increased when going from No. 71 to 80.

Another series chips of electroconductive cermet were made by tape casting using a cermet slurry composition containing the same proportions of binders, plasticizers and solvents as in Example 5, but no graphite powder and, as the ceramic component, an admixture of 40% PZT-8 and 60% of 1-10 $\mu$m nickel powder.

Then stacks were made by piling upon each other the chips numbered 71 to 80 in the order of increased porosity and inserting between each piezo-ceramic chip a cermet chip in staggered configuration to provide piezo-actuator electrodes. Staggered means here that the ceramic chips are alternatively off-set on right and left relatively to one another in the transverse direction so as to make them alternately project by about 0.3 mm on both sides of the stack. These stacks were pressed to effect compaction (20 MPa; 80°C) aid sintered at 1300°C for 1 hr. Thereafter a silver paint was applied on both sides of the block to connect the electrodes which alternately project from the respective sides thereof and final baking of the paint at 700°C was carried out. Afterwards the block was dipped into a pool of a molten silicone resin which filled the open porosity thereof.

There was thus obtained a piezo-actuator whose vibratory impedance is damped by the presence of the resin in graded proportion therethrough and residual non-infiltrated porosity; such damping effects matching the actuator vibrational energy with the absorbing impedance of the bodies of living being; hence the actuator can be directly applied on the skin of patients for sonic or ultrasonic therapy or diagnosis.

## Example 8

A slurry was prepared like in Example 1 but replacing the zirconia by a piezo-electric ceramic powder (PZT-501 A of Ultrasonics Powders Inc., South-Plainfield, N.J., USA).

The slurry was placed in a square mould 45 mm aside and 80 mm high with a porous bottom and centrifugated for 2 hrs under 30 g until all the water had filtered out. The resulting sedimented cake was dried in air at 110°C, then it was placed in an oven and sintered at 1300°C for 1 hr whereby the carbon has volatilized and a block with a porosity gradient was obtained. The pores were impregnated hot with molten silane-elastomer (Dow Corning MDX-4-4210) and electrodes were applied on sides of the block by means of a filled polymer silver paint. The transducer was finally poled at 90°C under 10 KV/cm for 5 min. An efficient transducer with damped vibrator impedance was obtained.

## Claims

1. A method of manufacturing hard composite bodies in which a ceramic material component and at least another non-ceramic material component are integrally interconnected through a transition phase comprising a mixture of said components in ratio graded according to a given profile, this method including the steps of:

   (1) making a ceramic material component to be surface-bound to said non-ceramic component, the structure of the material adjacent to said surface being porous with a porosity density varying according to said profile;

   (2) converting the non-ceramic component, or a precursor thereof, into a temporary fluid form capable of infiltrating into open porous structures;

   (3) contacting said porous structure of the ceramic material component with said non-ceramic component in fluid form so as to make it impregnate the pores thereof whereby, upon reconversion of the fluid to solid, there is obtained said transition phase with said non-ceramic component in graded admixture with the ceramic component;

   (4) integrally bind said ceramic and non-ceramic components using said transition phase interposed therebetween,

   characterized in that said porous structure of the ceramic component made under step (1) has a presintered fused morphology with at least 90% by volume open infiltrable porosity.

2. The method of claim 1, in which the amount of said non-ceramic component in fluid form exceeds that needed to fill the pores in the ceramic whereby, after solidification, a layer of the non-ceramic component is formed over the transition phase whereby step (4) can be omitted.

3. The method of claim 1, in which said non-ceramic component is selected from metals, glasses and resins which melt at temperatures below that of the melting of the ceramic and in which the impregnation is carried out by melting the non-ceramic component and forcing the liquid into the pores of the ceramic.

4. The method of claim 1, in which the non-ceramic component is in the form of a solution of a salt or an organic compound or a metal which is forced into the pores of the ceramic and in which the infiltrated salt or organic compound is thereafter decomposed to the metal by heat, evaporation or chemical reaction.

5. The method of claim 1, in which the non-ceramic component is incorporated into the porous ceramic in the form of a mixture of gaseous reactants which react within the pores to provide therein said non-ceramic component.

6. The method of claim 1, in which the graded porous ceramic structure of step (1) is made by:

(i) making a slurry of the ceramic in particulate powder form in a liquid and, in admixture therewith, a subsequently decomposable particulate material of specific weight below that of the ceramic,

(ii) pouring the slurry into a liquid absorbing mould and subjecting it to settling in a gravitational field, causing the ceramic particles to segregate by particle size by falling in the downward direction while the lower density particles segregate by rising in the upward direction and the liquid is absorbed by the mould, whereby a structure is obtained in which the ceramic packing density increases in the downward direction whereas the packing density of lighter particles increases in the upward direction,

(iii) drying the structure for consolidation into a green and firing the green to sinter into a fused porous ceramic with developed graded porosity by decomposing and driving off said decomposable particulate material.

7. The method of claim 6, in which said decomposable material is omitted, whereby the graded porosity results from the varying packing density of the ceramic particles.

8. The method of claim 7, in which the degree of segregation of the ceramic particles into a graded porosity network is amplified by generating gas bubbles in the slurry which will rise upwards during settling.

9. The method of claim 8, in which the bubbles are generated by dissolving a gas or air in the liquid under pressure and releasing said pressure suddenly.

10. The method of claim 6, in which the particles of the decomposable material are associated with another material which, upon decomposition of the decomposable material in step (iii) will remain as a solid in the pores of the porous ceramic structure, whereby step (3) of claim 1 is optional.

11. The method of claim 10, in which said another material is a coating of a metal or a metal precursor in which said decomposable material is at least partly encapsulated.

12. The method of claim 1, in which said porous structure of step (1) is obtained by :

(a1) making a plurality of thin ceramic green films containing, in admixture with the ceramic, a proportion of decomposable particulate material, this proportion being different for each film;

(b1) stacking the films over each other, the order of stacking being that of progressive change of the proportion of decomposable particles in the ceramic;

(c1) pressing the stack into a block to effect compaction and sinter under air to gasify the decomposable material, whereby a fused connected porous structure is formed upon discharge of the gaseous products.

13. The methods of claims 6 or 12, in which the decomposable particulate material is carbon, graphite or organic polymer beads which decompose by burning during sintering.

14. The method of claim 1, in which said porous structure is obtained by :

(a2) making a plurality of ceramic slurries containing, in admixture with the ceramic, a proportion of at least one pore generating additive, this proportion being different for each slurry;

(b2) making a laminate structure by applying on a ceramic substrate successive coatings of ceramic and pore generating additive by successively depositing layers of the slurries and drying the layers, the order of application being that of increasing proportions of pore generating additive;

(c2) firing the laminate to sinter into a fused block with developed graded porosity therethrough.

15. The method of claim 14, in which the layers are applied by spraying or dip coating.

16. The method of claim 15, in which the pore generator material is particulate organic material like carbon or polymer.

17. The method of claim 14, in which the pore generating material is a mineral fiber which, in admixture with the particulate ceramic, achieves upon firing a cross-linked matt-like structure whose porosity is in proportion to the fiber/particle ratio.

18. The method of claim 14, in which the mineral fibers are selected from alumino-silicate fibers, alumina fibers and ceramic whiskers such as SiC, TiC, $Si_3N_4$ and the like.

**European Patent Office**

# EUROPEAN SEARCH REPORT

Application Number

EP 91 81 0259

Page 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,Y | US-A-4936270 (H. USHIO ET AL) <br> * abstract; claims 1, 10-11, 14 * <br> * column 1, line 33 - column 2, line 33 * <br> * column 3, line 58 - column 4, line 65 * <br> * column 8, line 62 - column 9, line 26 * <br> --- | 1-3, <br> 6-7, 12 | C04B38/00 <br> C04B35/80 <br> B32B17/00 <br> H01L41/22 <br> C04B41/81 <br> C22C1/10 |
| Y | DE-A-3543342 (K. BOJAK) <br> * abstract; claims 1-4, 6-7, 10 * <br> * column 3, lines 13 - 31 * <br> * column 3, line 59 - column 4, line 59 * | 1-3, 12 | C04B37/02 |
| A | | 14, <br> 17-18 | |
| P,Y | --- <br> PATENT ABSTRACTS OF JAPAN, File Supplier JAPS. <br> &JP-A-2184580(Seiko Epson Corp.)19.07.1990 <br> --- | 6 | |
| Y | EP-A-250210 (THE REGENTS OF THE UNIVERSITY OF CALIFORNIA) <br> * abstract; claims 1-2, 17 * <br> * page 2, lines 39 - 45 * <br> * page 3, lines 28 - 40 * <br> * page 4, line 38 - page 5, line 56 * <br> * page 8, line 35 - page 40; figure 4 * <br> * example 1-2 * | 6-7 | |
| A | --- | 1, 4, 10 | TECHNICAL FIELDS SEARCHED (Int. Cl.5) <br><br> C04B <br> C22C |
| A | EP-A-230192 (AUTOMOBILES PEUGEOT) <br> * abstract; claims 1, 5 * <br> * column 1, lines 30 - 55 * <br> --- | 1-3, 14, <br> 17-18 | |
| A | DE-C-865721 (DEUTCHE EDELSTAHLWERKE AGS) <br> * page 1, line 1 - page 2, line 2 * <br> * page 2, lines 34 - 55 * <br> * page 2, lines 75 - 83; claims 1-2, 4, 6 * <br> --- | 1, 4 | |
| A | WORLD PATENT INDEX LATEST, Derwent Publications Ltd., LONDON, GB, Week 9009. <br> &JP-A-2018367(Epson Corp.)22.01.1990 <br> --- | 1, 6-7 | |
| | -/-- | | |
| | The present search report has been drawn up for all claims | | |

| Place of search | Date of completion of the search | Examiner |
|---|---|---|
| THE HAGUE | 17 JULY 1991 | OLSSON S.A. |

European Patent
Office

**EUROPEAN SEARCH REPORT**

Application Number

EP 91 81 0259
Page 2

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl.5) |
| A | GB-A-2168338 (DIDIER-WERKE AG)<br>* abstract; claims 1, 7, 9 *<br>* page 1, lines 13 - 65 *<br>* page 2, line 15 - page 3, line 13 *<br>--- | 1, 3,<br>14-18 | |
| A | DE-A-3724995 (RADEX-HERAKLITH<br>INDUSTRIEBETEILIGUNGS AG)<br>* abstract; claims 1-2, 4-8, 19 *<br>* column 4, line 60 - column 5, line 64; figure 3 *<br>* column 6, line 20 - column 7, line 4 *<br>* column 9, line 66 - column 11, line 10 *<br>--- | 1-3, 5,<br>12,<br>14-15 | |
| A | GB-A-1279156 (G. M. MANSFIELD)<br>* page 1, lines 10 - 89; claims 1-3 * * example 1 *<br>--- | 1, 6-9 | |
| A | PATENT OFFICE OF JAPAN, file supplier JAPS.<br>&JP-A-60021885(Mitsui Eng.& Shipbuild)04.02.1985<br>--- | 1, 5 | |
| A | FR-A-1600816 (ROLLS-ROYCE LTD.)<br>* page 1, line 1 - page 2, line 40 *<br><br>* page 5, lines 1 - 29 *<br>* page 7, lines 6 - 30 *<br>--- | 1,<br>12-14,<br>16 | TECHNICAL FIELDS<br>SEARCHED (Int. Cl.5) |
| A | CHEMICAL ABSTRACTS, vol. 111, no. 26, December 1989<br>Columbus, Ohio, USA<br>M. Kuwabara et al: "Ceramic articles for joining with metals"<br>page 337; ref. no. 238421Y<br>* abstract *<br>--- | 1, 3 | |
| | -/-- | | |

The present search report has been drawn up for all claims

| Place of search | Date of completion of the search | Examiner |
|---|---|---|
| THE HAGUE | 17 JULY 1991 | OLSSON S.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

  & : member of the same patent family, corresponding document

EPO FORM 1503 03.82 (P0401)

European Patent Office

**EUROPEAN SEARCH REPORT**

Application Number

EP    91 81 0259
Page 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-261067 (LANXIDE TECHNOLOGY COMPANY LP.)<br>* abstract; claims 1, 4-7, 11 *<br>* column 2, line 61 - column 3, line 58 *<br>* column 4, line 39 - page 5, line 45 *<br>* column 6, line 42 - column 8, line 20 *<br>* column 10, line 53 - column 11, line 4 *<br>* column 12, lines 35 - 58 *<br>----- | 1, 3-5 | |
| | | | TECHNICAL FIELDS SEARCHED (Int. Cl.5) |

The present search report has been drawn up for all claims

| Place of search | Date of completion of the search | Examiner |
|---|---|---|
| THE HAGUE | 17 JULY 1991 | OLSSON S.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)